(19) **Europäisches Patentamt**

**European Patent Office**

**Office européen des brevets**

(11) **EP 1 528 739 A1**

(12) **DEMANDE DE BREVET EUROPEEN**

(43) Date de publication:
**04.05.2005 Bulletin 2005/18**

(51) Int Cl.$^7$: **H04L 27/06**, H03M 1/00

(21) Numéro de dépôt: **04105380.2**

(22) Date de dépôt: **28.10.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **30.10.2003 FR 0350752**

(71) Demandeurs:
 • **ST MICROELECTRONICS S.A.**
  **92120 Montrouge (FR)**
 • **UNIVERSITE D'AIX-MARSEILLE I**
  **13331 MARSEILLE CEDEX (FR)**

(72) Inventeurs:
 • **Enguent, Jean-Pierre**
  **13119 Saint Savournin (FR)**
 • **Artigue, Olivier**
  **83160 La Valette du Var (FR)**
 • **Tetelin, Claude**
  **83210 Sollies Pont (FR)**

(74) Mandataire: **de Beaumont, Michel et al**
 **1bis, rue Champollion**
 **38000 Grenoble (FR)**

(54) **Démodulateur numérique à faible fréquence d'échantillonnage**

(57) L'invention concerne un procédé et dispositif de démodulation d'amplitude comprenant un convertisseur (21) échantillonnant un signal d'entrée dont la fréquence d'échantillonnage (fs) correspond à trois fois la fréquence de la porteuse (fp) de la modulation.

Fig 6

## Description

La présente invention concerne le domaine des démodulateurs numériques et plus particulièrement des démodulateurs au moins d'amplitude.

La présente invention s'applique, par exemple, aux systèmes à transpondeurs électromagnétiques, que ce soit côté borne ou côté transpondeur. L'invention s'applique plus particulièrement aux transpondeurs dépourvus d'alimentation autonome (par exemple, les cartes à puce sans contact) et aux bornes autonomes (sur batterie), par exemple les terminaux portables.

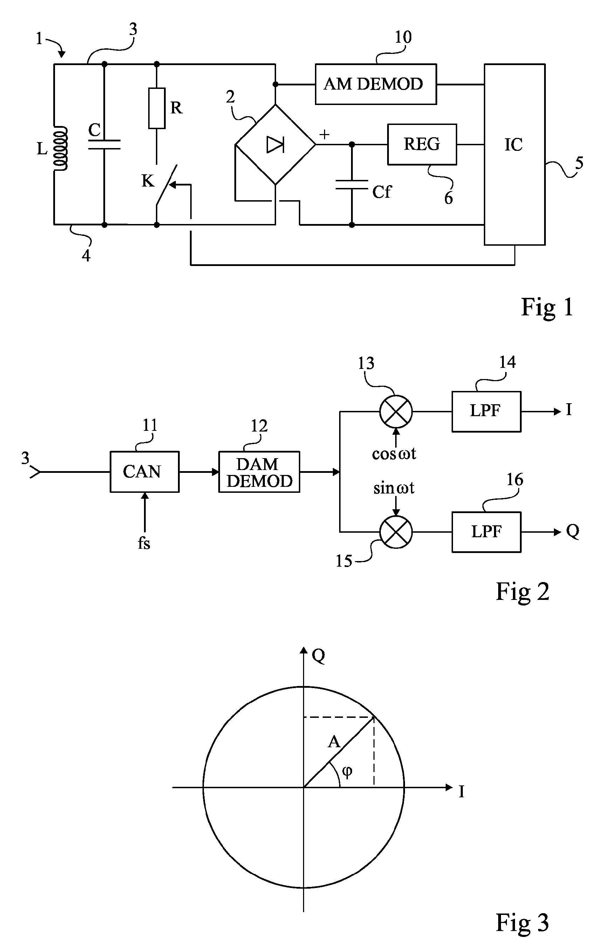

La figure 1 représente, de façon très schématique et sous forme de blocs, un exemple classique d'architecture de carte à puce sans contact du type auquel s'applique la présente invention.

Une telle carte à puce ou transpondeur est destiné à communiquer avec une borne de lecture-écriture (non représentée) et tire l'énergie nécessaire à l'alimentation des circuits qu'elle comporte d'un champ haute fréquence rayonné par la borne.

Un transpondeur comporte essentiellement un circuit oscillant constitué d'une inductance L en parallèle avec un condensateur C chargé de capter un champ haute fréquence (par exemple, 13,56 MHz). Un élément de redressement 2, par exemple double alternance, est connecté aux bornes 3 et 4 du circuit oscillant et fournit une tension continue, filtrée par un condensateur Cf d'alimentation, à des circuits applicatifs 5 (IC) du transpondeur. Le cas échéant, un régulateur linéaire 6 est intercalé entre la sortie redressée du pont 2 et la borne d'entrée d'alimentation des circuits 5.

La transmission d'informations depuis une borne de lecture-écriture (non représentée) vers un transpondeur s'effectue en modulant, au rythme d'une sous porteuse (par exemple, à 53 kHz) la porteuse de télé-alimentation (par exemple à 13,56 MHz) selon le code du message à transmettre. Cette modulation est une modulation d'amplitude avec un indice de modulation non nul. Côté transpondeur, un démodulateur d'amplitude 10 (AM DEMOD) est connecté sur l'une 3 des bornes du circuit oscillant en amont de l'élément de redressement et fournit au circuit 5 les informations démodulées.

La transmission d'informations du transpondeur vers la borne s'effectue au moyen d'une rétromodulation au rythme d'une sous porteuse (847,5 kHz). Cette rétromodulation consiste à modifier la charge du transpondeur sur le champ électromagnétique rayonné par la borne. Par exemple, une association série d'une résistance R et d'un interrupteur K commandé par le circuit 5 est connectée en parallèle sur le circuit oscillant 1. On peut également trouver des systèmes de rétromodulation capacitive. Côté borne, un démodulateur d'amplitude et de phase est prévu pour exploiter les données transmises par le transpondeur.

La présente invention concerne plus particulièrement la réalisation du démodulateur d'amplitude et éventuellement de phase d'un transpondeur électromagnétique ou d'une borne de lecture-écriture.

La conversion analogique-numérique des informations transmises s'effectue soit en aval de la démodulation qui est alors analogique, soit en amont d'un décodage numérique. L'invention concerne plus particulièrement le cas d'une démodulation qui requiert un échantillonnage du signal extrait du circuit oscillant avant d'attaquer le démodulateur. Généralement et pour simplifier, on considère alors l'échantillonnage comme faisant partie du démodulateur. Par convention, on appellera "démodulateur numérique" la partie du démodulateur située en aval de l'échantillonneur et qui fournit l'information démodulée, c'est-à-dire, les données numériques en bande de base (sans porteuse).

La figure 2 représente un exemple classique de démodulateur fournissant, à partir d'un signal modulé en amplitude, deux informations I et Q permettant de déterminer l'amplitude et la phase du signal sous-porteur, par exemple, dans une modulation QAM.

Le signal reçu (par exemple prélevé sur la borne 3 du transpondeur) est soumis à une conversion analogique-numérique ou échantillonnage (bloc 11, CAN) avec une fréquence d'échantillonnage fs avant d'attaquer un démodulateur numérique 12 (DAM DEMOD). Les échantillons fournis en sortie du démodulateur 12 sont soumis d'une part à une multiplication par cos(ωt), où ω représente la pulsation de la sous-porteuse et t le temps, avant de traverser un filtre passe-bas 14 (LPF) pour fournir l'information I, et d'autre part multipliés (multiplieur 15) par sin(ωt) avant de traverser un deuxième filtre passe-bas 16 (LPF) fournissant l'information Q.

La figure 3 illustre ce que représentent les informations I et Q sur un cercle trigonométrique de rayon A, où A désigne l'amplitude du signal sous-porteur. Connaissant I et Q, les valeurs de l'amplitude A et de la phase φ sont déterminées en appliquant les relations suivantes :

$$A = \sqrt{I^2 + Q^2} \; ;$$

et

$$\varphi = \text{Arctan} \, (Q/I) \, .$$

Pour que le démodulateur de la figure 2 fonctionne, il faut en pratique que la fréquence d'échantillonnage fs soit supérieure à quatre fois la fréquence de la porteuse véhiculant les données. En théorie (théorème de Shannon), la fréquence d'échantillonnage pourrait être égale à quatre fois la fréquence de la porteuse à condition que le signal à démoduler soit en phase avec la porteuse, ce qui en pratique est très rarement le cas. En particulier, pour des transpondeurs électromagnétiques, un déphasage apparaît obligatoirement par la variation de distance entre le transpondeur et la borne de sorte que cette condition ne peut pas être respectée. Classiquement, on utilise une fréquence d'échantillonnage supérieure à quatre fois la fréquence de la porteuse pour être sûr d'obtenir les informations I et Q de façon fiable pour n'importe quel échantillon.

Dans l'exemple des transpondeurs électromagnétiques où la fréquence de la porteuse est à 13,56 MHz, cela requiert une fréquence d'échantillonnage supérieure à 54,24 MHz. Or, plus la fréquence d'échantillonnage est élevée, plus la consommation du circuit mettant en oeuvre la conversion est importante. De plus, la consommation étant proportionnelle au carré de la tension d'alimentation, cela nécessite d'utiliser une technologie fine pour ne pas encore dégrader les performances de consommation, d'où une technologie coûteuse.

Le même problème se pose dans une borne de lecture et/ou écriture, notamment si elle est autonome, dont on souhaite minimiser la consommation.

Aujourd'hui, la seule solution pour diminuer la fréquence d'échantillonnage consiste à effectuer une démodulation analogique, puis à convertir en numérique les signaux démodulés. Toutefois, cela pose de nombreux problèmes, notamment d'adaptation d'impédance et d'équilibrage des voies I et Q. On préfère donc généralement numériser, le plus tôt possible dans la chaîne de réception, les signaux à exploiter.

La présente invention vise à diminuer la fréquence d'échantillonnage d'un convertisseur analogique-numérique en amont d'un démodulateur d'amplitude et éventuellement de phase.

L'invention vise plus particulièrement à diminuer la fréquence d'échantillonnage dans des applications à des systèmes de transpondeurs électromagnétiques et notamment de transpondeurs électromagnétiques téléalimentés de type carte à puce sans contact ou de bornes autonomes.

L'invention vise également à proposer un démodulateur numérique d'amplitude fiable et de constitution simple.

Pour atteindre ces objets ainsi que d'autres, la présente invention prévoit un démodulateur d'amplitude comprenant un convertisseur analogique-numérique dont la fréquence d'échantillonnage correspond à trois fois la fréquence de la porteuse de la modulation.

Selon un mode de réalisation de la présente invention, le démodulateur comporte des moyens de calcul de l'amplitude A d'un symbole d'un signal d'entrée appliquant la formule suivante :

$$A = k\sqrt{\sum_{i=1}^{3} e_i^2} \ ;$$

où $e_i$ désigne la valeur d'un échantillon numérisé de rang i parmi trois échantillons successifs fournis par ledit convertisseur, et où k désigne une constante.

Selon un mode de réalisation de la présente invention, la fréquence d'échantillonnage courante est obtenue en multipliant par trois la fréquence courante de porteuse extraite du signal d'entrée ou d'un générateur de référence.

L'invention prévoit également un démodulateur d'amplitude et de phase comportant :

des moyens de calcul d'amplitude ; et
des moyens de calcul de la phase d'un symbole à démoduler à partir de l'amplitude calculée et du signe de la valeur d'au moins un symbole adjacent.

L'invention concerne également un procédé de démodulation d'un signal modulé au moins en amplitude, consistant :

à effectuer une conversion analogique-numérique d'un signal d'entrée en appliquant une fréquence d'échantillonnage égale à trois fois la fréquence de la porteuse de la modulation ; et
à extraire l'information d'amplitude A de la relation suivante :

$$A = k\sqrt{\sum_{i=1}^{3} e_i^2} \ ;$$

où $e_i$ désigne la valeur d'un échantillon numérisé de rang i parmi trois échantillons successifs fournis par ledit convertisseur, et où k désigne une constante.

Selon un mode de mise en oeuvre de la présente invention, le signal d'entrée est modulé en phase et en amplitude, l'information de phase φ étant extraite d'un échantillon courant en appliquant la relation suivante :

$$\varphi = \text{Arccos } (e_i/A).$$

L'invention prévoit également un transpondeur électromagnétique comprenant :

un circuit oscillant propre à être excité par un signal à une première fréquence relativement élevée formant porteuse d'un deuxième signal modulé au moins en amplitude au rythme d'une deuxième fréquence relativement basse ; et
un démodulateur comportant :

un convertisseur analogique-numérique d'un signal prélevé aux bornes du circuit oscillant ; et

un décodeur numérique recevant le signal échantillonné et fournissant l'amplitude du signal à démoduler, la fréquence d'échantillonnage correspondant à trois fois la première fréquence.

L'invention prévoit également une borne de lecture et/ou écriture d'un système de communication à transpondeurs électromagnétiques comportant :

un circuit oscillant propre à être excité par un signal à une première fréquence relativement élevée formant porteuse d'un deuxième signal modulé au moins en amplitude au rythme d'une deuxième fréquence relativement basse ; et
un démodulateur comportant :

un convertisseur analogique-numérique d'un signal prélevé aux bornes du circuit oscillant ; et
un décodeur numérique recevant le signal échantillonné et fournissant l'amplitude du signal à démoduler, la fréquence d'échantillonnage correspondant à trois fois la première fréquence.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 décrite précédemment représente l'architecture d'un transpondeur électromagnétique du type auquel s'applique la présente invention ;
la figure 2 décrite précédemment représente un exemple classique de démodulateur numérique appliqué aux modulations avec sous-porteuse ;
la figure 3 décrite précédemment illustre les informations obtenues par le démodulateur de la figure 2 ;
la figure 4 représente, de façon très schématique et sous forme de blocs, un mode de réalisation d'un démodulateur numérique selon la présente invention ;
la figure 5 illustre l'exploitation des informations obtenues dans un démodulateur selon l'invention ; et
la figure 6 représente, de façon très schématique et sous forme de blocs, un mode de réalisation d'un démodulateur d'amplitude et de phase selon l'invention.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les circuits de calcul numérique n'ont pas été détaillés, l'invention pouvant être mise en oeuvre en utilisant des outils classiques. De plus, l'exploitation faite des signaux démodulés n'a pas été détaillée, l'invention pouvant être mise en oeuvre quelle que soit la destination des signaux démodulés qu'il s'agisse d'un système de carte à puce sans contact ou plus généralement de tout système de démodulation d'amplitude dans lequel on cherche à minimiser la valeur de la fréquence d'échantillonnage.
Une caractéristique de la présente invention est de prévoir une fréquence d'échantillonnage correspondant à trois fois la fréquence de la porteuse du signal à démoduler.
Selon l'invention, on utilise non pas une fréquence supérieure à quatre fois la fréquence de la porteuse indépendamment de la valeur exacte de celle-ci, mais une fréquence relativement précise correspondant à trois fois la fréquence de la porteuse. La précision requise pour la fréquence d'échantillonnage dépend de l'indice de modulation du signal à démoduler et des caractéristiques spectrales du signal informatif. Par exemple, dans une application aux transpondeurs électromagnétiques où l'indice de modulation est de 10 % dans une transmission lecteur vers carte, une précision de +/- 1% sur la fréquence d'échantillonnage suffit.

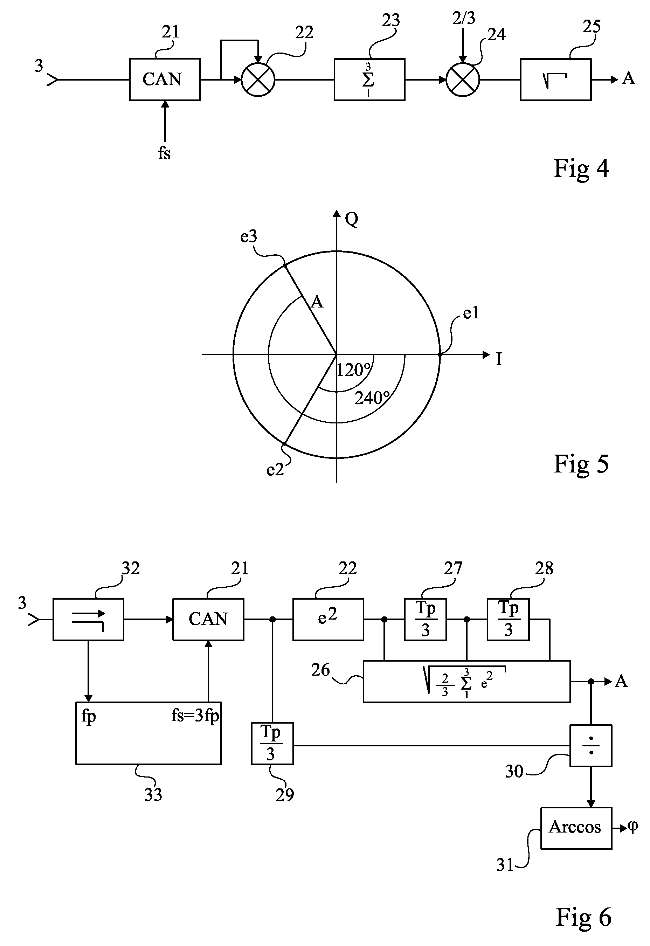

La figure 4 représente, de façon très schématique et sous forme de blocs, un mode de réalisation d'un démodulateur d'amplitude selon la présente invention. Le signal à démoduler (par exemple provenant d'un circuit oscillant 1 tel qu'illustré en figure 1) est envoyé sur un convertisseur analogique numérique 21 (CAN) dont la fréquence d'échantillonnage fs correspond à trois fois la fréquence du signal entrant. Les échantillons issus du convertisseur 21 sont élevés au carré (multiplieur 22 dont les deux entrées reçoivent le signal de sortie du convertisseur 21). Le traitement suivant consiste à sommer (bloc 23,

$$\sum_1^3$$

) trois échantillons successifs élevés au carré puis à multiplier (multiplieur 24) la somme par un facteur deux tiers (2/3). Enfin, la racine carrée (bloc 25, $\sqrt{}$) fournit l'amplitude A désirée. Cela revient à appliquer la formule suivante :

$$A = \sqrt{\frac{2}{3} \cdot \sum_{i=1}^{3} e_i^2} \; ;$$

où $e_i$ désigne la valeur de l'échantillon courant, c'est-à-dire la valeur numérique issue de la conversion. En variante, si une information proportionnelle à l'amplitude A suffit, le facteur 2/3 peut être omis ou remplacé par n'importe quelle constante k.
On notera que la description qui précède fait plus appel à une terminologie analogique pour des raisons de clarté alors que toutes les opérations effectuées en aval du convertisseur 21 s'effectuent au moyen d'outils numériques.

La figure 5 illustre le fonctionnement d'un démodulateur numérique selon l'invention. Cette figure représente un cercle trigonométrique de rayon A sur lequel ont été positionnés trois échantillons e1, e2 et e3 d'un même symbole à démoduler, issus du convertisseur 21. Comme la fréquence d'échantillonnage correspond à trois fois la fréquence de la porteuse, ces trois échantillons sont déphasés de 120° les uns par rapport aux autres. Pour simplifier, l'échantillon e1 a été placé avec un déphasage nul. On notera toutefois que cela n'a pas d'importance, l'important étant le déphasage de 120° entre les échantillons successifs.

Ainsi, dans le domaine temporel, on peut écrire que les valeurs numériques respectives des échantillons fournies par le convertisseur 21 correspondent :

pour l'échantillon e1, à $A*\cos(\omega p.t)$ ;
pour l'échantillon e2, à $A*\cos(\omega p.t+120°)$; et
pour l'échantillon e3, à $A*\cos(\omega p.t +240°)$, où $\omega p$ désigne la pulsation de la porteuse.

On peut donc extraire de ces trois échantillons (de la somme de ces trois échantillons élevés au carré), une valeur proportionnelle au carré de l'amplitude A de la modulation, sans se préoccuper de la phase du signal. A partir du moment où la fréquence d'échantillonnage est égale de façon relativement précise à trois fois la fréquence de la porteuse, cette somme est égale à $\frac{3}{2}$ $A^2$.

La sortie du bloc 26 fournit des valeurs au rythme de la fréquence d'échantillonnage (de façon synchrone avec la porteuse). L'exploitation des valeurs dépend de l'application et de la fréquence de la sous-porteuse. Par exemple, on sélectionne une valeur toutes les n valeurs, n étant choisi en fonction notamment du rapport entre les fréquences de sous-porteuse et échantillonnage. En reprenant l'exemple d'une modulation charge compris entre 1 et 10% avec les mêmes fréquences que précédemment, on peut sélectionner une valeur toutes les douze valeurs, ce qui fournit quatre valeurs par période de sous-porteuse et constitue un compromis acceptable pour déterminer les valeurs binaires en tenant compte du bruit.

Un avantage de l'invention est qu'elle permet de réduire la fréquence d'échantillonnage tout en obtenant l'amplitude quelle que soit la phase à l'origine du signal porteur. Réduire la fréquence d'échantillonnage d'un facteur 4 à un facteur 3 par rapport à la fréquence de la porteuse est particulièrement intéressant pour des applications à fréquences élevées. Par exemple, dans l'application transpondeur électromagnétique où la fréquence de la porteuse est de 13,56 MHz, une réduction de 25 % de la fréquence d'échantillonnage autorise une fréquence à 40,68 MHz au lieu d'une fréquence supérieure à 54,24 MHz. Pour une fréquence de porteuse de 27,125 MHz, la fréquence d'échantillonnage passe d'une fréquence supérieure à 108,5 MHz à une fréquence de 81,375 MHz.

La figure 6 représente un mode de réalisation de la présente invention dans lequel on souhaite également obtenir l'information de phase des échantillons dans le cadre d'une modulation de phase et d'amplitude d'informations transmises à un transpondeur.

Un tel mode de réalisation est à rapprocher de celui de la figure 2 où les données I et Q fournissent, à partir d'une fréquence d'échantillonnage supérieure à quatre fois la fréquence de la porteuse, les informations de phase et d'amplitude.

Selon le mode de réalisation de l'invention représenté en figure 6, la fréquence d'échantillonnage fs du convertisseur analogique numérique 21 reste de trois fois la fréquence de la porteuse fp comme en figure 4. La chaîne d'obtention de l'amplitude A applique un calcul similaire à celui de la figure 4. On commence par une élévation au carré (bloc 22, $e^2$) des échantillons fournis par le convertisseur 21. Puis, les résultats fournis par le bloc 22 sont transmis à la fois directement à un bloc 26 de calcul de la racine carrée de deux tiers de la somme de trois échantillons successifs élevés au carré

$$( \sqrt{\frac{2}{3} \sum_{1}^{3} e^2} ) ,$$

en même temps qu'à un élément retardateur 27 (Tp/3) d'un tiers de la période du signal porteur, donc de la valeur de la période d'échantillonnage Ts. La sortie de l'élément 27 est envoyée directement au bloc 26 ainsi qu'à un deuxième élément retardateur 28 (Tp/3) toujours d'un tiers de la période de la porteuse dont la sortie est envoyée au bloc 26. Les retards successifs apportés aux échantillons par les éléments 27 et 28 permettent que les valeurs présentes sur les trois entrées du bloc 26 correspondent aux trois échantillons successifs élevés au carré. Le bloc 26 fournit alors l'amplitude A.

L'information de phase est obtenue en calculant l'arc cosinus d'un échantillon divisé par son amplitude (normalisation de l'échantillon). Pour synchroniser l'obtention de l'amplitude avec l'échantillon courant, on utilise un élément retardateur 29 (Tp/3) du tiers de la période de la fréquence de la porteuse avant d'entrer dans un diviseur 30 qui divise l'échantillon par l'amplitude A. Le résultat de cette division est soumis à un calcul 31 (Arccos) d'arc cosinus qui fournit la phase $\varphi$. Ce calcul revient à appliquer la relation :

$$\varphi = Arccos\ (e/A).$$

Pour que cette détermination de phase soit possible, il faut mémoriser une référence précédente afin d'être en mesure de déterminer le signe positif ou négatif de la phase calculée (distinguer les échantillons e2 et e3 de la figure 5). Par exemple, on mémorise la valeur signée de la phase calculée précédemment ou la valeur d'au moins un échantillon adjacent (précédent et/ou suivant). Par la suite, ayant déterminé la valeur de la phase, on peut déduire son signe sachant que chaque échantillon est séparé du précédent par un angle de 120°. La mise en oeuvre d'un tel calcul de façon numérique est à la portée de l'homme du métier à partir des indications ci-dessus.

Dans le mode de réalisation de la figure 6, la fréquence d'échantillonnage est obtenue au moyen d'un coupleur 32 intercalé entre le circuit oscillant 3 et le convertisseur 21 pour extraire la fréquence de la porteuse fp soumise alors à un multiplieur (bloc 33) fournissant la fréquence fs. En variante, des circuits d'horloge séparés pourront être prévus. Toutefois, un avantage qu'il y a à déduire la fréquence d'échantillonnage d'une multiplication de la fréquence de la porteuse est que cela permet la précision requise de cette fréquence d'échantillonnage. En effet, et notamment dans l'application aux transpondeurs électromagnétiques, en cas de dérive de la fréquence de la porteuse, la fréquence d'échantillonnage suit cette dérive en temps réel et est donc asservie sur cette fréquence de porteuse.

Un avantage de la présente invention est alors qu'il est particulièrement aisé d'obtenir une valeur précise pour la fréquence d'échantillonnage qui garantisse le respect des contraintes de tolérance de dérive en fréquence d'échantillonnage.

Bien entendu, la présente invention est susceptible de diverses variantes et modifications qui apparaîtront à l'homme de l'art. En particulier, bien que par souci de clarté la description de l'invention ait été faite en employant un vocabulaire se rapprochant plus à une architecture de circuits dédiés en logique câblée ou à une technologie analogique, tous les traitements opérés en aval du convertisseur sont des traitements numériques qui pourront être effectués soit par des circuits successifs en logique câblée, soit par un processeur, le procédé de l'invention étant alors mis en oeuvre de façon logicielle. Cette mise en oeuvre pratique de l'invention au moyen d'outils numériques classiques est à la portée de l'homme du métier à partir des indications fonctionnelles données ci-dessus.

En outre, la modulation effectuée au rythme de la fréquence (sous-porteuse) relativement basse par rapport à la fréquence de la porteuse peut consister en une modulation de position, en une modulation multiniveaux, pourvu que la porteuse soit modulée en amplitude.

## Revendications

1. Démodulateur d'amplitude comprenant un convertisseur analogique-numérique dont la fréquence d'échantillonnage (fs) correspond à trois fois la fréquence de la porteuse (fp) de la modulation.

2. Démodulateur selon la revendication 1, comprenant des moyens (22, 23, 24, 25 ; 22, 26, 27, 28) de calcul de l'amplitude A d'un symbole d'un signal d'entrée appliquant la formule suivante :

$$A = k\sqrt{\sum_{i=1}^{3} e_i^2} \quad ;$$

où $e_i$ désigne la valeur d'un échantillon numérisé de rang i parmi trois échantillons successifs fournis par ledit convertisseur (21), et où k désigne une constante.

3. Démodulateur selon la revendication 1 ou 2, dans lequel la fréquence d'échantillonnage courante (fs) est obtenue en multipliant (33) par trois la fréquence courante de porteuse (fp) extraite (32) du signal d'entrée ou d'un générateur de référence.

4. Démodulateur d'amplitude et de phase, **caractérisé en ce qu'**il comporte :

des moyens de calcul d'amplitude conformes à l'une quelconque des revendications 1 à 3 ; et des moyens de calcul de la phase d'un symbole à démoduler à partir de l'amplitude calculée et du signe de la valeur d'au moins un symbole adjacent.

5. Procédé de démodulation d'un signal modulé au moins en amplitude, **caractérisé en ce qu'**il consiste :

à effectuer une conversion analogique-numérique d'un signal d'entrée en appliquant une fréquence d'échantillonnage (fs) égale à trois fois la fréquence de la porteuse (fp) de la modulation ; et
à extraire l'information d'amplitude A de la relation suivante :

$$A = k\sqrt{\sum_{i=1}^{3} e_i^2} \quad ;$$

où $e_i$ désigne la valeur d'un échantillon numérisé de rang i parmi trois échantillons successifs fournis par ledit convertisseur (21), et où k désigne une constante.

6. Procédé de démodulation selon la revendication 5, dans lequel le signal d'entrée est modulé en phase et en amplitude, l'information de phase φ étant extraite d'un échantillon courant en appliquant la relation suivante :

$$\varphi = \text{Arccos}\ (e_i/A).$$

7. Transpondeur électromagnétique comprenant :

un circuit oscillant (1) propre à être excité par un signal à une première fréquence relativement élevée formant porteuse d'un deuxième signal modulé au moins en amplitude au rythme d'une deuxième fréquence relativement basse ; et
un démodulateur comportant :

un convertisseur analogique-numérique (21) d'un signal prélevé aux bornes du circuit oscillant ; et
un décodeur numérique recevant le signal échantillonné et fournissant l'amplitude (A) du signal à démoduler, **caractérisé en ce que** la fréquence d'échantillonnage (fs) correspond à trois fois la première fréquence.

8. Transpondeur selon la revendication 7, dans lequel ledit démodulateur est conforme à l'une quelconque des revendications 1 à 4.

9. Borne de lecture et/ou écriture d'un système de communication à transpondeurs électromagnétiques comportant :

un circuit oscillant propre à être excité par un signal à une première fréquence relativement élevée formant porteuse d'un deuxième signal modulé au moins en amplitude au rythme d'une deuxième fréquence relativement basse ; et
un démodulateur comportant :

un convertisseur analogique-numérique (21) d'un signal prélevé aux bornes du circuit oscillant ; et
un décodeur numérique recevant le signal échantillonné et fournissant l'amplitude (A) du signal à démoduler, **caractérisé en ce que** la fréquence d'échantillonnage (fs) correspond à trois fois la première fréquence.

10. Borne selon la revendication 9, dans laquelle ledit démodulateur est conforme à l'une quelconque des revendications 1 à 4.

Fig 1

Fig 2

Fig 3

## Fig 4

## Fig 5

## Fig 6

**Office européen des brevets**

**RAPPORT DE RECHERCHE EUROPEENNE**

Numéro de la demande

EP 04 10 5380

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 4 973 977 A (REYNOLDS THOMAS B ET AL) 27 novembre 1990 (1990-11-27) * abrégé * * colonne 1, ligne 5 - ligne 10 * * colonne 4, ligne 38 - ligne 41 * ----- | 1,3,7-10 | H04L27/06 H03M1/00 |
| X | EP 0 461 720 A (PHILIPS NV) 18 décembre 1991 (1991-12-18) * colonne 1, ligne 10 - ligne 15 * * colonne 2, ligne 23 - ligne 26 * * colonne 2, ligne 56 - colonne 3, ligne 5 * * colonne 4, ligne 20 - ligne 35 * ----- | 1,3,7-10 | |

**DOMAINES TECHNIQUES RECHERCHES (Int.Cl.7)**

H04L
H03M

Le présent rapport a été établi pour toutes les revendications

| Lieu de la recherche | Date d'achèvement de la recherche | Examinateur |
|---|---|---|
| La Haye | 1 décembre 2004 | Litton, R |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
...............................................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.** EP 04 10 5380

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-12-2004

| Document brevet cité au rapport de recherche | | Date de publication | Membre(s) de la famille de brevet(s) | | Date de publication |
|---|---|---|---|---|---|
| US 4973977 | A | 27-11-1990 | AU | 618433 B2 | 19-12-1991 |
| | | | AU | 4634589 A | 26-06-1990 |
| | | | CA | 1323104 C | 12-10-1993 |
| | | | EP | 0446239 A1 | 18-09-1991 |
| | | | JP | 4506132 T | 22-10-1992 |
| | | | WO | 9006631 A1 | 14-06-1990 |
| EP 0461720 | A | 18-12-1991 | NL | 9001359 A | 02-01-1992 |
| | | | AU | 649449 B2 | 26-05-1994 |
| | | | AU | 7840291 A | 19-12-1991 |
| | | | DE | 69107247 D1 | 23-03-1995 |
| | | | DE | 69107247 T2 | 07-09-1995 |
| | | | EP | 0461720 A1 | 18-12-1991 |
| | | | FI | 912832 A | 16-12-1991 |
| | | | JP | 3171606 B2 | 28-05-2001 |
| | | | JP | 4233358 A | 21-08-1992 |
| | | | KR | 201745 B1 | 15-06-1999 |
| | | | US | 5157343 A | 20-10-1992 |

EPO FORM P0460

Pour tout renseignement concernant cette annexe : voir Journal Officiel de l'Office européen des brevets, No.12/82